Europäisches Patentamt

European Patent Office

Office européen des brevets

(19)

(11) EP 0 961 326 A1

(12) DEMANDE DE BREVET EUROPEEN

(43) Date de publication:
01.12.1999 Bulletin 1999/48

(51) Int Cl.$^6$: H01L 29/861

(21) Numéro de dépôt: 99410073.3

(22) Date de dépôt: 25.05.1999

(84) Etats contractants désignés:
AT BE CH CY DE DK ES FI FR GB GR IE IT LI LU
MC NL PT SE
Etats d'extension désignés:
AL LT LV MK RO SI

(30) Priorité: 27.05.1998 FR 9806859

(71) Demandeur: STMicroelectronics S.A.
94250 Gentilly (FR)

(72) Inventeur: Rivet, Bertrand
49100 Angers (FR)

(74) Mandataire: de Beaumont, Michel
1bis, rue Champollion
38000 Grenoble (FR)

(54) Association de diodes en série

(57) L'invention concerne une diode haute tension rapide à l'ouverture, constituée d'une association en série de plusieurs diodes (D'1, D'2), la dispersion intrinsèque relative de charges recouvrées ($\Delta Qrri/Qrri$) entre lesdites diodes étant inférieure à 5%.

Fig 5

## Description

La présente invention concerne la réalisation d'une diode rapide susceptible de supporter une tension inverse élevée par l'association en série de plusieurs diodes.

On dispose classiquement de deux solutions lorsque l'on souhaite réaliser une diode haute tension. Une première solution consiste à dimensionner la diode par fabrication, c'est-à-dire à fabriquer une diode dont la tension d'avalanche est adaptée à la haute tension que la diode doit supporter en inverse. Une deuxième solution classique consiste à associer plusieurs diodes en série de sorte que la somme de leurs tensions d'avalanche respectives corresponde à la tension d'avalanche souhaitée pour la diode haute tension. Cette deuxième solution est souvent préférée lorsque l'on souhaite favoriser la rapidité de la diode, c'est-à-dire un faible temps de commutation lors du passage de l'état conducteur en direct à un état bloqué en inverse.

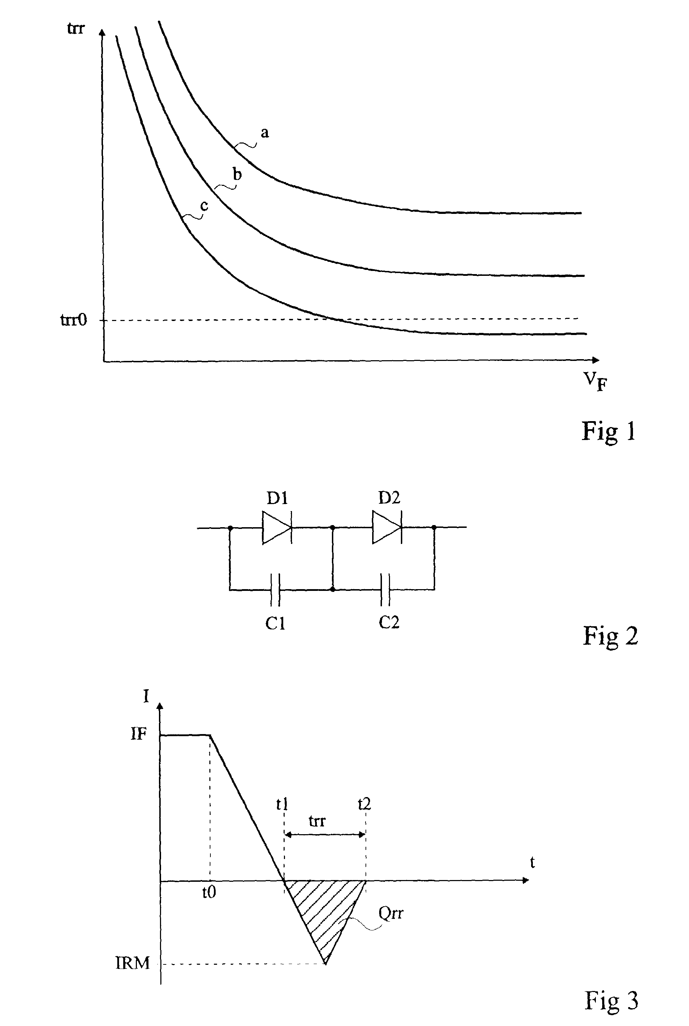

La figure 1 illustre la caractéristique temps de recouvrement trr en fonction de la tension directe VF de la diode. Plusieurs courbes caractéristiques a, b, c ont été tracées pour des diodes ayant des tensions d'avalanche différentes. Par exemple, la courbe a correspond à une diode ayant une tension d'avalanche Vrma d'environ 1200 volts. La courbe b correspond à la caractéristique d'une diode ayant une tension d'avalanche Vrmb de l'ordre de 600 volts et la courbe c correspond à la caractéristique d'une diode ayant une tension d'avalanche Vrmc d'environ 300 volts.

Cette figure 1 montre que le temps de recouvrement d'une diode dépend de sa tension d'avalanche et de sa chute de tension directe. Plus la tension directe de la diode est faible, ce qui est avantageux dans la mesure où cela limite la puissance dissipée lorsque la diode conduit, plus le temps de recouvrement est élevé.

Cette figure montre également que, quand on souhaite un faible temps de recouvrement (par exemple trr0 à la figure 1), cela ne peut pas être obtenu avec n'importe quelle diode et cela requiert de choisir une diode ayant une tension d'avalanche suffisamment faible. Si la diode doit tenir une tension inverse supérieure, on est généralement conduit à associer plusieurs diodes en série pour obtenir la tenue en tension inverse souhaitée par sommation des tensions d'avalanche de ces diodes associées en série. On utilisera, par exemple, deux diodes ayant une même tension d'avalanche de 300 volts pour former une diode rapide ayant une tension d'avalanche de 600 volts. Bien entendu, la chute de tension en direct de la diode haute tension obtenue correspond à la somme des chutes de tension en direct des diodes associées en série.

La figure 2 illustre l'association en série de deux diodes D1, D2 destinées à jouer le rôle d'une diode haute tension. De façon classique, on place un condensateur C1, C2 en parallèle sur chaque diode pour constituer un réseau d'équilibrage dynamique. Le rôle des condensateurs C1 et C2, dont les valeurs sont déterminées empiriquement et sont de l'ordre de plusieurs centaines de picofarads, est de minimiser l'influence d'un déséquilibre entre les charges recouvrées des deux diodes en série.

Les charges recouvrées d'une diode se définissent comme étant l'intégration en fonction du temps du courant inverse traversant la diode lors de son blocage. Cette définition est illustrée par la figure 3 qui représente, schématiquement, le courant I dans une diode en fonction du temps lors de son blocage. On suppose qu'à un instant t0, on inverse la polarité aux bornes d'une diode en imposant au courant de varier avec une pente constante. Ainsi, le courant I décroît depuis une valeur IF correspondant au courant traversant la diode en direct avant blocage, jusqu'à une valeur négative Irm avant de croître pour s'annuler. La durée (entre les instants t1 et t2) pendant laquelle la diode est traversée par un courant inverse est appelée temps de recouvrement en inverse trr. Cette durée est nécessaire à l'évacuation des charges stockées restantes lorsque le courant direct s'annule (instant t1). On appelle ces charges restantes, les charges recouvrées. La quantité de charges recouvrées dépend de plusieurs facteurs et, en particulier, de la pente de décroissance du courant lors du blocage de la diode. Les autres paramètres intervenant sur la quantité de charges recouvrées sont notamment le courant IF traversant la diode avant blocage, la température de jonction en fonctionnement, et la tension appliquée en inverse à la diode pour la bloquer.

Lors de la commutation à l'ouverture d'une diode, celle-ci peut, en première approximation, être modélisée par deux capacités en parallèle, l'une représentant la capacité de jonction de la diode et l'autre une capacité liée aux charges recouvrées Qrr.

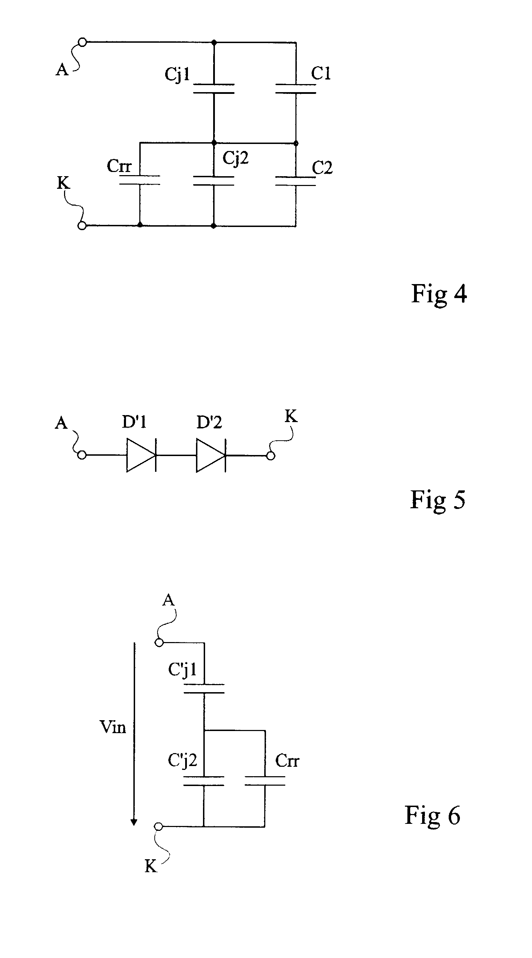

La figure 4 représente un schéma électrique équivalent au schéma de la figure 2 en fin de commutation, lors du blocage.

On suppose que les diodes D1 et D2 ont des charges recouvrées respectives différentes l'une de l'autre d'une valeur ΔQrr, la charge recouvrée de la diode D2 étant supérieure à celle de la diode D1. A la figure 4, on a modélisé les deux diodes à l'instant où la diode D1 a évacué toutes ses charges recouvrées et où il ne reste plus à la diode D2 qu'à évacuer le surplus de charges recouvrées ΔQrr qu'elle a par rapport à la diode D1. La diode D1 est donc modélisée par sa capacité de jonction Cj1 et la diode D2 est modélisée par sa capacité de jonction Cj2 en parallèle avec une capacité Crr liée au surplus de charges recouvrées ΔQrr qu'il reste à la diode D2 à évacuer. En effet, le courant qui circule en inverse dans les diodes associées en série est le même, de sorte que la différence de charges recouvrées entre les deux diodes se traduit, en fin de blocage, par la présence d'une capacité de charges recouvrées en parallèle sur la capacité de jonction d'une seule des deux diodes.

En l'absence des condensateurs C1 et C2, lorsque la diode D1 a éliminé toutes ses charges recouvrées, elle se trouve à l'état bloqué alors que la deuxième diode contient encore des charges recouvrées, c'est-à-dire qu'elle est passante en inverse. Toute la tension inverse se retrouve alors aux bornes de la première diode. Cette première diode étant choisie avec une tension d'avalanche légèrement supérieure à la moitié de la tension inverse appliquée, elle entre donc en avalanche.

Ainsi, dans l'art antérieur, on a considéré qu'il était nécessaire de prévoir des condensateurs d'équilibrage externes C1 et C2 pour minimiser l'influence de la capacité Crr liée aux charges recouvrées en phase finale du blocage des diodes. Pour cela, on prévoit généralement deux condensateurs de valeur importante, de sorte à rendre les capacités Cj1 et Cj2+Crr négligeables devant les capacités des condensateurs C1 et C2 (figure 2).

Un exemple d'application dans lequel on utilise souvent des diodes associées en série pour améliorer le temps de commutation d'un système de diode haute tension est le domaine des alimentations à découpage. La recherche d'un temps de commutation trr le plus faible possible est ici liée à une recherche de minimiser les pertes d'énergie par dissipation lors des commutations.

La présence de condensateurs d'équilibrage nuit à la miniaturisation et augmente le coût des alimentations à découpage et autres systèmes dans lesquels on souhaite réaliser une diode rapide haute tension par association en série de plusieurs diodes. En outre, les condensateurs accroissent les pertes par dissipation lors des commutations.

La présente invention vise à permettre la réalisation d'une diode haute tension rapide par l'association en série de plusieurs diodes en minimisant le recours à des condensateurs d'équilibrage dynamique.

Une caractéristique de la présente invention est d'associer en série plusieurs diodes, toutes dimensionnées pour présenter une même tension d'avalanche, et choisies pour présenter les unes par rapport aux autres une dispersion limitée en charges recouvrées associée, de préférence, à une dispersion relative limitée de valeur de chute de tension en direct. Ainsi, au lieu de chercher à résoudre les problèmes d'équilibrage dynamique des diodes associées en série au moyen de composants externes, la présente invention propose, à l'inverse, de mettre l'accent sur les diodes elles-mêmes.

Plus particulièrement, la présente invention prévoit une diode haute tension rapide à l'ouverture, constituée d'une association en série de plusieurs diodes, la dispersion intrinsèque relative de charges recouvrées entre lesdites diodes étant inférieure à 5%.

Selon un mode de réalisation de la présente invention, la dispersion relative en chute de tension en direct entre lesdites diodes est inférieure à 5%.

Selon un mode de réalisation de la présente invention, la diode haute tension rapide est constituée d'une association en série de n diodes, la dispersion absolue en charges recouvrées entre lesdites diodes étant inférieure à la différence entre n fois la tension d'avalanche minimale d'une des diodes en série et n - 1 fois la tension nominale inverse pour laquelle est prévue ladite diode haute tension, multipliée par la capacité de jonction d'une des diodes en série, ladite capacité de jonction étant donnée à 80% de la tension d'avalanche d'une des diodes en série.

Selon un mode de réalisation de la présente invention, lesdites diodes associées en série sont prélevées sur une même tranche de silicium.

Selon un mode de réalisation de la présente invention, la diode est constituée d'une association en série de plusieurs diodes, prélevées en étant voisines sur une même tranche de silicium sur laquelle elles sont réalisées.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

les figures 1 à 4 qui ont été décrites précédemment sont destinées à exposer l'état de la technique et le problème posé ;

la figure 5 représente un circuit de diodes en série selon la présente invention ; et
la figure 6 représente le schéma équivalent des deux diodes de la figure 5 en fin de commutation au blocage.
La figure 5 représente une diode rapide haute tension selon la présente invention pourvue d'une borne d'anode A et d'une borne de cathode K. Cette diode est constituée d'au moins deux diodes D'1 et D'2 associées en série entre les bornes A et K. La figure 6 est un schéma électrique équivalent de ces deux diodes en fin de commutation à l'ouverture. La diode D'1 y est modélisée par sa capacité de jonction C'j1 et la diode D'2 par sa capacité de jonction C'j2 en parallèle avec une capacité Crr représentant la différence de charges recouvrées ΔQrr entre les deux diodes.

Selon un premier aspect de la présente invention, les diodes D'1 et D'2 ont une même tension d'avalanche (aux dispersions technologiques près) et ces diodes sont appariées de telle sorte que, dans l'application à laquelle la diode rapide haute tension est destinée, la condition suivante soit respectée :

$$\Delta Qrr < Cj(2Vrm - Vin), \qquad (1)$$

où Vrm représente la tension d'avalanche minimale d'une des diodes, Vin représente la tension inverse nominale que doit pouvoir supporter la diode haute tension dans l'application considérée, et où Cj représente la capacité de jonction d'une des diodes, donnée à 80% de la tension d'avalanche. On considère que les diodes D'1 et D'2 ont des capacités de jonction respectives (C'j1, C'j2) identiques (Cj).

Selon l'invention, un circuit comprenant deux diodes associées en série et respectant la condition (1) ci-dessus n'a pas besoin d'être associé à un réseau d'équilibrage dynamique.

En effet, la condition qui doit être respectée pour éviter le recours à des condensateurs externes d'équilibrage dynamique, est que la tension V1 aux bornes de la capacité de jonction C'j1 reste toujours inférieure à la tension d'avalanche Vrm de la diode D'1.

La tension V1 peut s'exprimer sous la forme :

$$V1 = Vin - V2,$$

où V2 représente la tension aux bornes de la capacité de jonction C'j2.

En première approximation, on peut considérer que, lorsque la diode D'1 a évacué toutes ses charges recouvrées (cas modélisé en figure 6), la tension V2 peut s'exprimer sous la forme suivante :

$$V2 = (CjVin - \Delta Qrr)/2Cj,$$

la capacité Crr pouvant s'exprimer sous la forme $\Delta Qrr/V2$.

Il en découle que la tension V1 qui doit être inférieure à Vrm peut s'exprimer sous la forme :

$$(CjVin + \Delta Qrr)/2Cj.$$

Plus généralement, pour une association en série de n diodes, la condition qui, selon la présente invention, doit être respectée pour éviter le recours à un réseau d'équilibrage dynamique est :

$$\Delta Qrr < Cj(nVrm - (n - 1)Vin).$$

Un avantage de la présente invention selon son premier aspect est qu'elle permet de disposer d'une diode haute tension rapide qui, dans l'application pour laquelle elle est prévue, permet d'éviter le recours à des condensateurs d'équilibrage dynamique.

Selon un deuxième aspect de la présente invention, on considère que la différence globale $\Delta Qrr$ de charges recouvrées entre deux diodes associées en série a essentiellement deux origines. Une première quantité de différence de charges recouvrées $\Delta Qrri$ est considérée comme intrinsèque aux diodes et provenant, en particulier, des dispersions technologiques liées à leur fabrication. On appellera par la suite cette quantité, la différence intrinsèque de charges recouvrées. Une deuxième quantité de différence de charges recouvrées $\Delta Qrrf$ est considérée comme provenant de l'environnement et du fonctionnement des diodes. On appellera par la suite cette quantité, la différence fonctionnelle de charges recouvrées. La différence globale de charges recouvrées correspond à la somme des différences intrinsèque et fonctionnelle ($\Delta Qrr = \Delta Qrri + \Delta Qrrf$).

Une caractéristique de la présente invention est, selon ce deuxième aspect, de choisir les diodes à associer en série de sorte que la dispersion intrinsèque relative ($\Delta Qrri/Qrri$) de charges recouvrées des diodes les unes par rapport aux autres soit inférieure à 5%. Ainsi, selon ce deuxième aspect, toutes les diodes en série D'1, D'2 (figure 5) d'un circuit selon l'invention sont choisies pour avoir des quantités intrinsèques de charges recouvrées voisines. Avec une telle dispersion intrinsèque relative de charges recouvrées, on réduit considérablement la valeur de la capacité Crr (figure 6) se trouvant en parallèle sur une des capacités de jonction en fin de commutation des diodes au blocage.

Une autre caractéristique de la présente invention selon ce deuxième aspect est de prévoir que les diodes constitutives d'un même circuit de diodes en série aient une dispersion relative de chute de tension en direct ($\Delta VF/VF$) inférieure à 5%.

En limitant la dispersion de chute de tension en direct, on minimise la quantité de variation de charges recouvrées $\Delta Qrrf$ qui est liée à l'environnement et au fonctionnement des diodes. En effet, on peut considérer que la quantité $\Delta Qrrf$ dépend essentiellement de la différence entre les températures de jonction des diodes ($\Delta Tj$).

Or, cette différence des températures de jonction entre les diodes peut s'exprimer, en première approximation, de la façon suivante :

$$\Delta Tj = P.\Delta Rth + Rth.\Delta P,$$

où Rth désigne la résistance thermique jonction-boîtier et où P désigne la puissance dissipée. Cette puissance dissipée est directement proportionnelle à la tension directe des diodes.

Par conséquent, en minimisant la dispersion relative en tension directe, on minimise la dispersion en puissance dissipée et, par voie de conséquence, la différence des températures de jonction.

Avec de telles diodes, la capacité Crr liée à la dispersion totale (intrinsèque et fonctionnelle) de charges recouvrées est minimisée. Il en découle que les condensateurs d'équilibrage qu'il est nécessaire de placer en parallèle sur chacune des diodes peuvent, selon ce second aspect de l'invention, être à tout le moins de capacité plus faible qu'avec un appariement de diodes quelconques et, dans la majorité des applications, être supprimés (les capacités de jonction suffisant à l'équilibre dynamique).

Pour que les condensateurs d'équilibrage externes puissent être omis, il suffit que, lors de la coupure des diodes, la tension réappliquée aux bornes de la diode D'1 (la diode ayant le moins de charges recouvrées) reste inférieure à sa tension d'avalanche. Cette condition est remplie si la capacité Crr est suffisamment faible devant la capacité Cj2 avec laquelle elle est en parallèle (figure 6).

A titre d'exemple particulier de réalisation, dans une application de la présente invention à une alimentation à découpage ou à un circuit de correction du facteur de puissance, on prévoit un circuit de diodes en série selon la présente invention pour constituer la diode de puissance. On utilise, par exemple, deux diodes ayant chacune une tension d'avalanche Vrm de 300 volts pour constituer une diode ayant une tension d'avalanche de 600 volts, mais ne voyant en commutation à l'ouverture, généralement qu'une tension Vin de l'ordre de 450 volts. En prenant le cas de deux diodes dont les capacités de jonction respectives sont de l'ordre de 25 picofarads et d'un circuit alimenté à partir de la tension alternative du secteur (220 volts), le respect des conditions ci-dessus sur la dispersion intrinsèque relative en charges recouvrées ($\Delta Qrri/Qrri$) et sur la dispersion relative en tension directe ($\Delta VF/VF$), permet de se passer de condensateurs d'équilibrage sans pour autant que l'une des deux diodes soit en avalanche lors du blocage.

Ainsi, l'invention apporte dans tous les cas un gain en encombrement et en coût et minimise les pertes d'énergie.

On notera que la mesure des charges recouvrées s'effectue à une température donnée, en partant d'un courant direct (IF, figure 3) donné, et avec une pente de décroissance du courant donnée pour une tension réappliquée en inverse donnée.

Les conditions de détermination de la quantité Qrri sont, par exemple, une tension réappliquée Vr de 200 volts, un courant direct IF de 8A, une pente de décroissance du courant dI/dt de 200 A/µs, et une température de jonction de 125°C.

Une autre caractéristique de la présente invention est de prévoir une solution particulièrement simple pour associer plusieurs diodes en série qui respectent les conditions d'association fixées ci-dessus.

Selon la présente invention, un circuit de plusieurs diodes en série est, de préférence, constitué de plusieurs diodes prises à proximité les unes des autres sur une même tranche de silicium. Une telle solution permet de minimiser les effets des dispersions technologiques entre les différentes puces. Une telle solution est nettement préférable par rapport à un tri des diodes dans un lot pour sélectionner deux ou plusieurs diodes respectant les critères choisis. En effet, une sélection par tri entraîne plus de pertes (c'est-à-dire un nombre de composants plus important ne pouvant pas être utilisé en respectant les conditions fixées), surtout si ce tri est effectué sur les deux critères de la dispersion intrinsèque relative en charges recouvrées et en tension directe. Le fait de prélever deux puces voisines sur une même plaquette de silicium dans laquelle ont été réalisées les diodes permet de respecter les deux conditions d'une dispersion intrinsèque relative en charges recouvrées inférieure à 5% et d'une dispersion en tension directe inférieure à 5% sans qu'il soit nécessaire d'effectuer des mesures de tri complexes.

Un avantage de la présente invention est qu'elle permet la réalisation de circuits de diodes haute tension associant plusieurs diodes en série qui allient des caractéristiques de rapidité (faible temps de recouvrement trr) et de haute tension d'avalanche, sans qu'il soit nécessaire de prévoir des condensateurs de valeur importante pour un réseau d'équilibrage dynamique. Dans la plupart des cas, la présente invention permet même d'éviter entièrement le recours à un réseau d'équilibrage dynamique.

Bien entendu, la présente invention est susceptible de diverses variantes et modifications qui apparaîtront à l'homme de l'art. En particulier, la détermination du besoin de condensateurs d'équilibrage externes pour un circuit de diodes respectant les conditions du second aspect de l'invention est à la portée de l'homme du métier. Il suffit pour cela de vérifier si le critère du premier aspect de l'invention prenant en compte l'application est ou non respecté en fonction de l'application à laquelle sont destinées les diodes considérées.

## Revendications

1.  Diode haute tension rapide constituée d'une association en série de n diodes (D'1, D'2), caractérisée en ce que la dispersion absolue en charges recouvrées ($\Delta Qrr$) entre lesdites diodes est inférieure à la différence entre n fois la tension d'avalanche minimale (Vrm) d'une des diodes en série et n - 1 fois la tension nominale inverse (Vin) pour laquelle est prévue ladite diode haute tension, multipliée par la capacité de jonction d'une des diodes en série, ladite capacité de jonction étant donnée à 80% de la tension d'avalanche d'une des diodes en série, et la dispersion intrinsèque relative de charges recouvrées ($\Delta Qrri/Qrri$) entre lesdites diodes étant inférieure à 5%.

2.  Diode selon la revendication 1, caractérisée en ce que la dispersion relative en chute de tension en direct ($\Delta VF/VF$) entre lesdites diodes est inférieure à 5%.

3.  Diode selon la revendication 1 ou 2, caractérisée en ce que lesdites diodes associées en série sont prélevées sur une même tranche de silicium.

4.  Diode selon la revendication 3, caractérisée en ce qu'elle est constituée d'une association en série de plusieurs diodes, prélevées en étant voisines sur une même tranche de silicium sur laquelle elles

sont réalisées.

Fig 1

Fig 2

Fig 3

Fig 4

Fig 5

Fig 6

Office européen
des brevets

**RAPPORT DE RECHERCHE EUROPEENNE**

Numéro de la demande

EP 99 41 0073

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | PATENT ABSTRACTS OF JAPAN vol. 6, no. 107 (E-113), 17 juin 1982 (1982-06-17) & JP 57 036853 A (NIPPON TELEGR & TELEPH CORP), 27 février 1982 (1982-02-27) * abrégé * | 1 | H01L29/861 |
| A | DE 36 43 994 A (NISSAN MOTOR CO., LTD.) 2 juillet 1987 (1987-07-02) * le document en entier * | 1-4 | |
| A | PATENT ABSTRACTS OF JAPAN vol. 8, no. 231 (E-274), 24 octobre 1984 (1984-10-24) & JP 59 114851 A (NIPPON DENKI KK), 3 juillet 1984 (1984-07-03) * abrégé * | 1 | |
| A | DE 25 21 848 A (BBC AG BROWN, BOVERI & CIE) 4 novembre 1976 (1976-11-04) * le document en entier * | 1-4 | DOMAINES TECHNIQUES RECHERCHES (Int.Cl.6) H01L |

Le présent rapport a été établi pour toutes les revendications

| Lieu de la recherche | Date d'achèvement de la recherche | Examinateur |
|---|---|---|
| LA HAYE | 24 août 1999 | Baillet, B |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**    EP 99 41 0073

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

24-08-1999

| Document brevet cité au rapport de recherche | | Date de publication | Membre(s) de la famille de brevet(s) | | Date de publication |
|---|---|---|---|---|---|
| JP 57036853 | A | 27-02-1982 | AUCUN | | |
| DE 3643994 | A | 02-07-1987 | JP | 62150597 A | 04-07-1987 |
| JP 59114851 | A | 03-07-1984 | AUCUN | | |
| DE 2521848 | A | 04-11-1976 | CH | 584456 A | 31-01-1977 |

EPO FORM P0460

Pour tout renseignement concernant cette annexe : voir Journal Officiel de l'Office européen des brevets, No.12/82